## Europäisches Patentamt
## European Patent Office
## Office européen des brevets

(19)

(11) Veröffentlichungsnummer: **0 015 864**
**B1**

(12)

# EUROPÄISCHE PATENTSCHRIFT

(45) Veröffentlichungstag der Patentschrift:
**04.01.84**

(51) Int. Cl.³: **G 01 R 27/02**, G 01 R 27/16, G 01 R 27/26, H 02 H 7/26

(21) Anmeldenummer: **80730007.4**

(22) Anmeldetag: **06.02.80**

(54) **Schaltungsanordnung zur Bestimmung der Reaktanz einer Energieübertragungsleitung im Kurzschlussfalle.**

(30) Priorität: **28.02.79  DE 2907857**

(43) Veröffentlichungstag der Anmeldung:
**17.09.80 Patentblatt 80/19**

(45) Bekanntmachung des Hinweises auf die Patenterteilung:
**04.01.84 Patentblatt 84/1**

(84) Benannte Vertragsstaaten:
**BE CH FR GB IT NL SE**

(56) Entgegenhaltungen:
**DD - A - 51 929**
**DE - A - 2 704 762**
**DE - A - 2 717 681**
**DE - B - 2 032 578**
**DE - B - 2 339 932**
**US - A - 3 479 586**

(73) Patentinhaber: **SIEMENS AKTIENGESELLSCHAFT,**
**Berlin und München Wittelsbacherplatz 2,**
**D-8000 München 2 (DE)**

(72) Erfinder: **Born, Eckhard, Dipl.-Phys., Potsdamer**
**Chaussee 48 B, D-1000 Berlin 38 (DE)**
Erfinder: **Schaale, Jörg, Dipl.-Ing., Remscheider**
**Strasse 30, D-1000 Berlin 20 (DE)**

# Schaltungsanordnung zur Bestimmung der Reaktanz einer Energieübertragungsleitung im Kurzschlussfalle

Die Erfindung bezieht sich auf eine Schaltungsordnung zur Bestimmung der Reaktanz einer Energieübertragungsleitung im Kurzschlussfalle.

Es ist in der Selektivschutztechnik seit langem bekannt (vgl. beispielsweise H. Titze «Fehler und Fehlerschutz in elektrischen Drehstromanlagen», Springer- Verlag Wien 1953, Seiten 18 und 19), dass sich durch Messung des Widerstandes einer Energieübertragungsleitung zwischen der Einbaustelle einer Schutzanordnung und dem Ort eines Fehlers die Entfernung des Fehlerortes von der Einbaustelle ermitteln lässt, da der Widerstand der Entfernung proportional ist. Es ist ferner - beispielsweise auch aus der genannten Literaturstelle - bekannt, die Reaktanz der Energieübertragungsleitung zwischen Einbaustelle der Schutzanordnung und dem Kurzschluss zu messen; bei der Erfassung der Reaktanz ergibt sich der Vorteil, das die Bestimmung des Kurzschlussortes vom Lichtbogenwiderstand oder von den Erdübergangswiderständen nur geringfügig beeinflusst wird. Die Reaktanz Xk einer Energieübertragungsleitung im Kurzschlussfall lässt sich durch folgende Gleichung (1) beschreiben

$$Xk = \frac{|\hat{U}k|}{|\hat{I}k|} \cdot \sin\varphi_k \qquad (1)$$

In dieser Gleichung gibt $|\hat{U}k|$ den Scheitelwert der Kurzschlussspannung an der Übertragungsleitung und $|\hat{I}k|$ den Scheitelwert des Kurzschlussstromes in der Übertragungsleitung, gemessen an der Einbaustelle der Schutzanordnung, wieder; mit $\varphi_k$ ist der Phasenwinkel zwischen der Kurzschlussspannung und dem Kurzschlussstrom bezeichnet.

Um zur Bestimmung des Kurzschlussortes auf einer Energieübertragungsleitung die Reaktanz der Leitung im Kurzschlussfalle zu erfassen, bedarf es demzufolge der Ermittlung von $|\hat{U}k|$, $|\hat{I}k|$ und von $\sin\varphi_k$ sowie der mathematischen Verknüpfung dieser Grössen. Dies lässt sich bei dem heutigen Stand der elektronischen Schaltungstechnik ohne weiteres durchführen, wenn dafür eine genügend lange Zeit zur Verfügung steht.

Es ist eine Schutzanordnung für Energieübertragungsleitungen bekannt (DE-A-27 04 762), bei der die Impedanz einer Energieübertragungsleitung erfasst wird, um daraus auf die Lage der Fehlerstelle im Kurzschlussfalle schliessen zu können. Die bekannte Schutzanordnung enthält in üblicher Weise ein Leitungsabbild, um eine aus dem Kurzschlussstrom abgeleitete Messgrösse zu gewinnen. Diese Messgrösse wird zusammen mit einer aus der Kurzschlussspannung abgeleiteten weiteren Messgrösse nach Gleichrichtung und Glättung über einen Analog-Digital-Umsetzer einem Prozessrechner zugeführt. Der Phasenwinkel zwischen den beiden Messgrössen wird dadurch erfasst, dass eine stromproportionale, um 90° phasenverschobene Spannung an einer Drossel des Leitungsabbildes abgegriffen wird und gemeinsam mit der weiteren Messgrösse über eine Binäreingangsgruppe dem Prozessrechner zugeführt wird.

Es ist ferner eine Impedanz-Messeinrichtung (US-A-479 586) bekannt, in der der Quotient des Absolutwertes einer der Leitungsspannung proportionalen Spannung und des Absolutwertes einer dem Leitungsstrom proportionalen Messgrösse gebildet wird. Zu diesem Zweck enthält die bekannte Messeinrichtung einen Phasenschieber, dem eingangsseitig die dem Leitungsstrom proportionale Messgrösse zugeführt ist; mittels eines nachgeordneten Phasenkomparators ist dafür gesorgt, dass von dem Phasenschieber jeweils eine solche Phasendrehung bewirkt wird, dass die dem Leitungsstrom proportionale Messgrösse in Phase mit der der Leitungsspannung proportionalen Spannung ist. Mittels eines Dividierers kann dann aus diesen Grössen die Impedanz ermittelt werden. Zur genauen Bestimmung der Entfernung des Fehlerortes auf der Leitung von der Einbaustelle der Messeinrichtung ist diese ungeeignet, weil bei der Impedanzmessung ein Lichtbogenwiderstand oder Erdübergangswiderstände berücksichtigt werden.

Es ist auch ein Verfahren zum Ermitteln von Fehlern auf einem zu überwachenden Leitungsabschnitt eines elektrischen Energieversorgungsnetzes bekannt (DE-B-23 39 932), bei dem in jeder Halbschwingung des Leitunsstromes mindestens eine aus dem Leitungsstrom abgeleitete Hilfsgrösse gebildet wird; diese Hilfsgrösse bestimmt je Halbschwingung ein Messintervall. Die Fehlerermittlung wird in jeweils dem Messintervall durchgeführt, dessen Beginn in einem zeitlichen Abstand von nahezu einer Halbperiode auf den Beginn des vorangehenden Zeitintervalls folgt, wodurch Fehlmessungen infolge Sättigung der Stromwandler vermieden werden.

Bei einer weiteren bekannten Schaltungsanordnung zum Messen der Fehlerstellenentfernung bei Leitungskurzschlüssen (DE-B-20 32 578) werden mittels analoger Messwertgeber Gleichspannungen erzeugt, die der Leitungsspannung und dem Leitungsstrom proportional sind. Den Messwertgebern sind Spannungs-Frequenzumsetzer nachgeordnet, deren Ausgänge zu einer Anordnung zur digitalen Quotientenbildung geführt sind. Beeinflussungen des Messergebnisses durch einen Lichtbogenwiderstand werden dadurch ausgeschlossen, dass ein analoger Messwertgeber als Blindspannungsgeber ausgeführt ist, indem er eingangsseitig sowohl vom Leitungsstrom als auch von der Leitungsspannung beeinflusst ist.

Der Erfindung liegt die Aufgabe zugrunde, eine Schaltungsanordnung zur Bestimmung der Reaktanz einer Energieübertragungsleitung im Kurzschlussfalle vorzuschlagen, mit der sich die Reaktanz und damit auch der Kurzschluss in sehr kurzer Zeit aus den Messgrössen $|\hat{U}k|$ und $|\hat{I}k|$ ermitteln lässt; dies wird deshalb angestrebt, um mit der Schaltungsanordnung zur Bestimmung der Reaktanz nach dem Ansprechen einer Anregeschaltung im Kurzschlussfalle oder nach Ausgabe eines Auslösesignals durch eine zugeordnete Schutzeinrichtung in der kurzen Zeit vor dem Abschalten der nachgeordneten Leistungsschalter mit Sicherheit die Reaktanz und damit auch den Kurzschluss genau bestimmen können.

Die Lösung dieser Aufgabe ist Gegenstand des Anspruchs 1.

Der wesentliche Vorteil der erfindungsgemässen Schaltungsanordnung zur Bestimmung der Reaktanz besteht darin, dass eine Hilfsmessgrösse gebildet wird, die der einen Messgrösse um etwa den der Phasendifferenz zwischen Strom und Spannung bei metallischem Kurzschluss entsprechenden Phasenwinkel voreilt, so dass die Hilfsmessgrösse dabei stets schon vor dem Beginn der Bestimmung der Reaktanz bzw. des Kurzschlussortes erzeugt wird und zu ihrer Bildung kein zusätzlicher Zeitverlust eintritt. Durch die gewählte Phasendrehung der einen Messgrösse wird erreicht, dass die Hilfsmessgrösse und die weitere Messgrösse zu Beginn der Bestimmung der Reaktanz in ihrer Phasenlage sich in der Regel nur geringfügig voneinander unterscheiden, so dass in kurzer Zeit d.h. nahezu gleichzeitig, Maximalwerte der Messgrössen erfassbar sind und gespeichert werden können.

Auch hinsichtlich der Erfassung der vom Phasenwinkel zwischen den beiden Messgrössen abhängigen Ausgangsgrösse erweist sich die erfindungsgemässe Schaltungsanordnung als vorteilhaft, weil aufgrund der Auswertung der Hilfsmessgrösse der Phasenwinkel zwischen dieser und der weiteren Messgrösse in der Regel relativ klein ist und somit ebenfalls in kurzer Zeit ermittelt werden kann.

Es lassen sich also mittels der erfindungsgemässen Schaltungsanordnung die Maximalwerte von Strom und Spannung der Energieübertragungsleitung im Kurzschlussfalle und auch eine von dem Phasenwinkel zwischen ihnen abhängige Grösse schnell ermitteln und damit unter Benutzung einer einfachen Rechenanordnung in kurzer Zeit Reaktanz und Kurzschlussort bestimmen.

Um Ungenauigkeiten bei der Bestimmung der Reaktanz bzw. des Kurzschlussortes durch nichtnetzfrequente Störgrössen - wie sie insbesondere bei längeren, kompensierten Übertragungsleitungen im Hochspannungsnetz auftreten - zu vermeiden, sind den Schaltern auf die Netzfrequenz abgestimmte Bandpässe mit gleichem elektrischem Verhalten vorgeordnet. Am Eingang des einen Bandpasses steht daher die Hilfsmessgrösse und am Eingang des anderen Bandpasses die weitere Messgrösse an. Beide Bandpässe sind demzufolge mit Grössen in der Regel etwa gleicher Phase beaufschlagt und zeigen daher übereinstimmendes Einschwingverhalten, so dass die zur Bestimmung der Reaktanz benötigte Zeit durch die Bandpässe nicht nennenswert verlängert wird.

Es hat sich ferner als vorteilhaft herausgestellt, wenn die Auswertanordnung eingangsseitig zwei Rechteckformer enthält, von denen der eine an seinem Ausgang eine der Hilfsmessgrösse entsprechende Rechteckschwingung und der andere eine der weiteren Messgrösse entsprechende weitere Rechteckschwingung erzeugt; die Ausgänge der beiden Rechteckformer sind an ein Exklusiv-ODER-Glied angeschlossen, und dem Exklusiv-ODER-Glied ist eine Umsetzeranordnung nachgeordnet, die an ihrem Ausgang die vom Phasenwinkel zwischen den beiden Messgrössen abhängige Ausgangsgrösse erzeugt.

Die Umsetzeranordnung enthält eingangsseitig vorteilhafterweise einen Generator, der während der Zeitdauer eines Ausgangssignals des Exklusiv-ODER-Gliedes an seinem Ausgang eine entsprechende Anzahl von Impulsen erzeugt, und dem Generator ist ein Zähler nachgeordnet. Die Umsetzeranordnung kann jedoch auch einen anderen Aufbau aufweisen; der beschriebene Aufbau erscheint vom Aufwand her aber besonders günstig.

Bei einer Ausführungsform der erfindungsgemässen Schaltungsanordnung kann der Ausgang des Zählers unmittelbar mit dem Multiplexer verbunden sein; in diesem Falle wird dem Multiplexer eine Grösse zugeführt, die ein Mass für den Phasenwinkel zwischen der weiteren Messgrösse und der Hilfsmessgrösse darstellt und damit auch abhängig vom Phasenwinkel zwischen der einen und der weiteren Messgrösse ist. Die Reaktanz bzw. der Kurzschlussort lassen sich damit zwar nur näherungsweise, in vielen Fällen aber mit hinreichender Genauigkeit ermitteln.

Ist eine noch genauere Bestimmung der Reaktanz erwünscht, z.B. bei relativ kurzen Leitungsabschnitten, dann ist an den Zähler vorteilhafterweise ein PROM angeschlossen, das an seinem Ausgang eine dem Sinus des Phasenwinkels zwischen den beiden Messgrössen entsprechende Ausgangsgrösse erzeugt. In das Rechenwerk wird in diesem Falle über den Multiplexer also genau der Wert des Sinus zwischen Kurzschlussspannung und Kurzschlussstrom eingegeben und bei der Bestimmung der Reaktanz berücksichtigt.

Die Anordnung zur Maximalwertspeicherung kann unterschiedlich ausgebildet sein. Als vorteilhaft wird es jedoch angesehen, wenn sie zwei Maximalwertspeicher enthält, von denen der eine an den einen Schalter und der andere an den anderen Schalter der erfindungsgemässen Schaltungsanordnung angeschlossen ist.

Jeder Maximalwertspeicher kann seinerseits in unterschiedlicher Weise aufgebaut sein. Als vorteilhaft erscheint es, die erfindungsgemässe Schaltungsanordnung mit Maximalwertspeichern mit einem Kondensator auszurüsten, dem ein Schalter parallel geschaltet ist, und mit einem Komparator, der mit seinen Eingängen an einen Anschlusspunkt des Kondensators und an eine Eingangsklemme der Schaltungsanordnung angeschlossen ist, wobei der Kondensator mit seinem einen Anschlusspunkt über den genannten Schalter an die eine Eingangsklemme der Schaltungsanordnung angeschlossen und der Ausgang des Komparators mit dem Betätigungseingang des weiteren Schalters verbunden ist.

Der Vorteil bei der Verwendung eines derartigen Maximalwertspeichers besteht darin, dass der gespeicherte Maximalwert dem tatsächlichen Maximalwert weitestgehend entspricht, weil die Eigenschaften der beteiligten elektronischen Bauelemente auf die Güte der Speicherung nahezu keinen Einfluss haben.

Die Verknüpfung des Ausgangs des Komparators mit dem Eingang des genannten Schalters kann bei der erfindungsgemässen Schaltungsanordnung in unterschiedlicher Weise erfolgen; als vorteilhaft wird es angesehen, wenn der Betätigungseingang des genannten Schaltes über einen Widerstand mit einem Abgriff eines an den Ausgang des Komparators angeschlossenen Spannungsteilers verbunden ist. Diese Art der schaltungstechnischen Verbindung zwischen dem Ausgang des Komparators und dem Betätigungseingang des genannten Schalters bietet den Vorteil, dass der Betätigungseingang des weiteren Schalters über eine Diode mit einem Ausgang einer Steuereinrichtung verbunden und an einen weiteren Ausgang der Steuereinrichtung der Betätigungseingang des einen Schalters angeschlossen werden kann.

Ist die Steuereinrichtung an den Ausgang einer Anregeschaltung oder einer Distanzschutzanordnung angeschlossen, dann kann sowohl die Entladung der Kondensatoren der Maximalwertspeicher als auch der Speichervorgang der Hilfsmessgrösse und der weiteren Messgrösse selbsttätig in einer vorgegebenen Weise ablaufen.

Bei der erfindungsgemässen Schaltungsanordnung kann die Analog-Digital-Wandleranordnung für jeden Maximalwertspeicher einen Analog-Digital-Wandler enthalten. Zur Vereinfachung des Schaltungsaufbaus erscheint es jedoch vorteilhafter, wenn die Analog-Digital-Wandleranordnung aus einem Analog-Digital-Wandler besteht, der über einen Umschalter mit seinem Eingang mit den Ausgängen der beiden Maximalwertspeicher verbindbar ist.

Zur Erläuterung der Erfindung ist in

Fig. 1 ein Ausführungsbeispiel der erfindungsgemässen Schalteranordnung in Form eines Blockschaltbildes, in

Fig. 2 ein Zeitdiagramm zur Erläuterung der Wirkungsweise der Steuereinrichtung, in

Fig. 3 ein Vektordiagramm zur Erläuterung der Wirkungsweise der erfindungsgemässen Schaltungsanordnung und in

Fig. 4 ein Ausführungsbeispiel eines Maximalwertspeichers einer im Rahmen der Erfindung bevorzugten Ausführung wiedergegeben.

An einem Eingang 1 der erfindungsgemässen Schaltungsanordnung liegt eine Messgrösse $\overrightarrow{Ui}$, die aus dem Kurzschlussstrom in der zu überwachenden, nicht dargestellten Energieübertragungsleitung abgeleitet ist. An den Eingang 1 ist ein Phasendrehglied 2 angeschlossen, in dem aus der einen Messgrösse $\overrightarrow{Ui}$ eine Hilfsmessgrösse $\overrightarrow{Uh}$ gebildet wird. Die Hilfsmessgrösse $\overrightarrow{Uh}$ eilt der einen Messgrösse $\overrightarrow{Ui}$ um einen Phasenwinkel vor, der der Phasendifferenz zwischen Kurzschlussstrom und Kurzschlussspannung an der Energieübertragungsleitung bei metallischem Kurzschluss entspricht; zweckmässigerweise ist im Hinblick auf die praktischen Gegebenheiten die Hilfsgrösse $\overrightarrow{Uh}$ um 80° zur einen Messgrösse $\overrightarrow{Ui}$ voreilend.

Der Phasendreheinrichtung 2 ist ein Bandpass 3 nachgeordnet, dessen Ausgang mit einem Schalter 4 verbunden ist. Einem weiteren Schalter 5 ist ein weiterer Bandpass 6 vorgeordnet, der in seinem Übertragungsverhalten dem des einen Bandpasses 3 entspricht. Eingangsseitig liegt an dem weiteren Bandpass 6 eine weitere Messgrösse $\overrightarrow{Uu}$ die aus der Kurzschlussspannung an der Übertragungsleitung abgeleitet ist. Die Schalter 4 und 5 können so ausgeführt sein, wie aus dem RCA-Handbuch «RCA COS/MOS Integrated Circuits», 1977, Seiten 91 ff. hervorgeht.

An den Eingang des einen Schalters 4 ist ein Eingang 7 einer Auswerteanordnung 8 angeschlossen. Ein weiterer Eingang 9 der Auswerteanordnung 8 steht mit dem Eingang des weiteren Schalters 5 in Verbindung. Ausserdem sind mit den Ausgängen der Schalter 4 und 5 Eingänge 10 und 11 einer Anordnung 12 zur Maximalwertspeicherung verbunden.

Ein Ausgang 13 der Auswerteanordnung 8, an den eine von dem Phasenwinkel zwischen den Messgrössen $\overrightarrow{Ui}$ und $\overrightarrow{Uu}$ abhängige Ausgangsgrösse auftritt, ist an einen Multiplexer 14, beispielsweise gemäss RCA-Handbuch «COS/MOS Integrated Circuits», 1977, Seiten 165 ff. ausgeführt angeschlossen. An dem Multiplexer 14 liegt eingangsseitig ausserdem eine Analog-Digital-Wandleranordnung, die im dargestellten Ausführungsbeispiel aus einem einzigen Analog-Digital-Wandler 15, z.B. Baustein C MOS 8750 entsprechend der Druckschrift «C MOS 8750 - Monolithischer Analog-Digital-Wandler 3½ Digit mit BCD-Ausgängen» der Fa. Teledyne Semiconductor, besteht. Diesem Analog-Digital-Wandler 15 ist ein Umschalter 16 vorgeordnet, bei dem es sich vorteilhafterweise um einen elektronischen Umschalter handelt, dessen Eingänge 17 und 18 mit Ausgängen 19 und 20 der Anordnung 12 zur Maximalwertspeicherung verbunden sind. Als Umschalter kann derselbe elektronische Baustein wie für die Schalter 4 und 5 verwendet werden.

Die dargestellte Schaltungsanordnung enthält ferner ein Steuerwerk 21, das über einen Ausgang 22 der Auswerteanordnung 8 angesteuert wird und seinerseits über einen Ausgang 23 auf die Auswerteanordnung 8 zurückwirkt. Über weitere Ausgänge 24, 25, und 26 werden vom Steuerwerk der Umschalter 16, der Analog-Digital-Wandler 15 und ein Schalter 27 zur Aktivierung des Multiplexers 14 gesteuert. Ein zusätzlicher Ausgang 28 des Steuerwerkes 29 ist unmittelbar mit dem Multiplexer 14 verbunden. Dem Multiplexer 14 ist ein Rechenwerk 29 nachgeordnet, an dem aufgrund eines ebenfalls mit dem Multiplexer 14 verbundenen Faktor-Gebers 30 der Fehlerort in Prozenten der zu überwachenden Leitungsstrecke ablesbar ist. Das Rechenwerk 29 ist z.B. von einer «BCD-Recheneinheit gemäss einem Applikationsbericht «BCD-Recheneinheit TMSO117NC» der Fa. Texas Instruments Deutschland GmbH gebildet.

Im dargestellten Ausführungsbeispiel ist der erfindungsgemässen Schalteranordnung eine Distanzschutzeinrichtung 31 zugeordnet, die nicht nur die eine Messgrösse $\vec{U}_i$ und die weitere Messgrösse $\vec{U}_u$ abgibt, sondern auch im Kurzschluss falle an ihrem Ausgang 32 ein Auslösesignal für in der Figur nicht dargestellte, zugeordnete Leistungsschalter erzeugt. An dem Ausgang 32 ist eine Steuereinrichtung 33 der erfindungsgemässen Schaltungsanordnung angeschlossen, die mit ihrem einen Ausgang 34 mit einem Betätigungseingang 35 des einen Schalters 4 und einem Betätigungseingang 36 des weiteren Schalters 5 sowie mit ihrem anderen Ausgang 37 mit der Anordnung 12 zur Maximalwertspeicherung verbunden ist.

Die Auswerteanordnung 8 weist eingangsseitig zwei Rechteckformer 40 und 41 (vgl. z.B. RCA-Handbuch «COS/MOS Integrated Circuits», 1977, Seiten 154 ff) auf, die an ihren Ausgängen Rechteckschwingungen entsprechend den Nulldurchgängen der Hilfsmessgrösse $\vec{U}_h$ und der weiteren Messgrössen $\vec{U}_u$ erzeugen. Den beiden Rechteckformern 40 und 41 ist ein Exklusiv-ODER-Glied 42 nachgeordnet. Das Exklusiv-ODER-Glied 42 kann so ausgeführt sein, wie es aus dem RCA-Handbuch «COS/MOS Intergrated Circuits» 1977, Seite 123 ff beschrieben ist. Ein Freigabe-Eingang des Exklusiv-ODER-Gliedes 42 ist mit dem Ausgang 34 der Steuereinrichtung 33 verbunden.

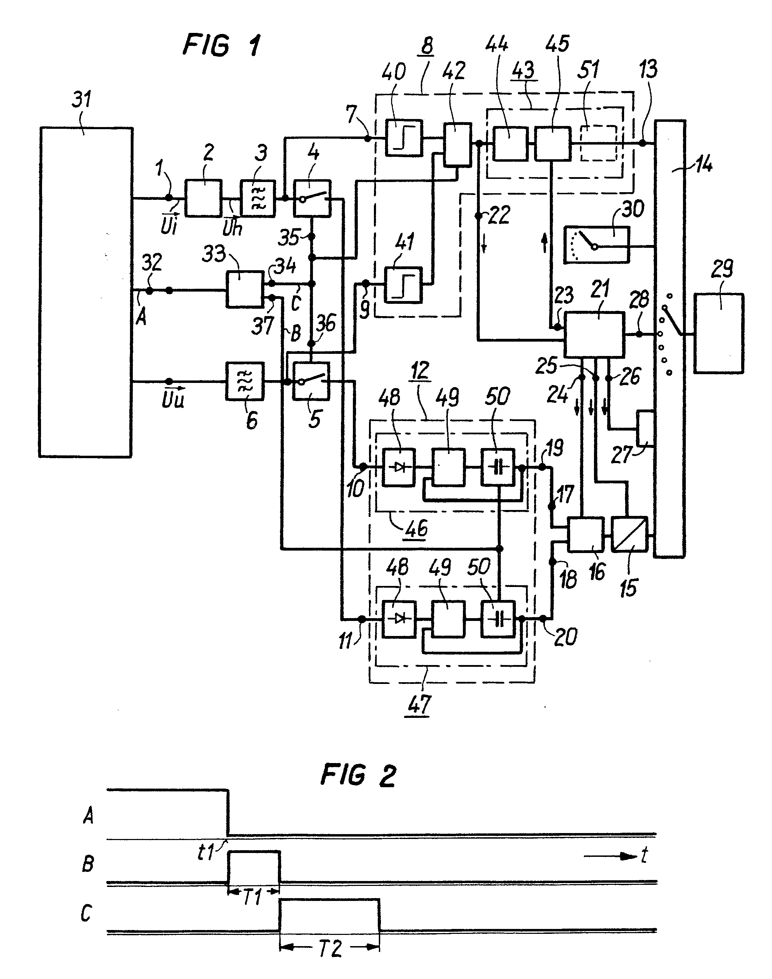

An den Ausgang des Exklusiv-ODER-Gliedes 42 ist eine Umsetzeranordnung 43 angeschlossen, die eingangsseitig einen Synchrongenerator 44 enthält; der Synchrongenerator 44 kann beispielsweise gemäss RCA-HANDBUCH «COS/MOS Integrated Circuits», 1977 Seite 154 ff. ausgeführt sein. Dem Synchrongenerator 44 ist ein Zähler 45 nachgeschaltet, bei dem es sich beispielsweise um einen Zähler gemäss dem genannten RCA-Handbuch «COS/MOS Integrated Circuits» Seite 104 ff. handeln kann. Der Zähler 45 ist - wie es in Fig. 1 mittels der durchgehenden Linie angedeutet ist - unmittelbar mit dem Eingang 13 des Multiplexers 14 verbunden, der von einer Anordnung gemäss dem wiederholt angeführten RCA-Handbuch «COS/MOS «Integrated Circuits» Seite 165 ff. gebildet sein kann.

Die Anordnung 12 zur Maximalwertspeicherung enthält einen Maximalwertspeicher 46 und einen weiteren Maximalwertspeicher 47. Der Maximalwertspeicher 46 und 47 sind identisch aufgebaut, so dass sich die Beschreibung auf einen von ihnen beschränken kann. Jeder Maximalwertspeicher 46 bzw. 47 weist eingangsseitig einen Gleichrichter, vorzugsweise einen aktiven Gleichrichter 48, auf, an den über eine elektronische Schaltung 49 ein Kondensator 50 angeschlossen ist. Der jeweils eine Anschlusspunkt des Kondensators 50 des einen Maximalwertspeichers 46 ist mit dem Ausgang 19 der Anordnung 12 und der entsprechende Anschlusspunkt des Kondensators 50 des weiteren Maximalwertspeicher 47 ist an den Ausgang 20 der Anordnung 12 angeschlossen.

Weitere Einzelheiten der erfindungsgemässen Schaltungsanordnung nach Fig. 1 werden anhand der Wirkungsweise im folgenden näher erläutert:

Wird von der Distanzschutzanordnung 31 ein Fehler auf der zu überwachenden Energieübertragungsleitung erkannt, dann wird von ihr an ihrem Ausgang 32 ein Auslösesignal erzeugt, dessen Verlauf im Diagramm A der Fig. 2 über der Zeit t wiedergegeben ist. Mit dem zum Zeitpunkt t1 erscheinenden Auslösesignal wird die Steuereinrichtung 33 beaufschlagt, die an ihrem Ausgang 37 für eine Zeitdauer T1 ein Signal erzeugt (siehe Diagramm B der Fig. 2).

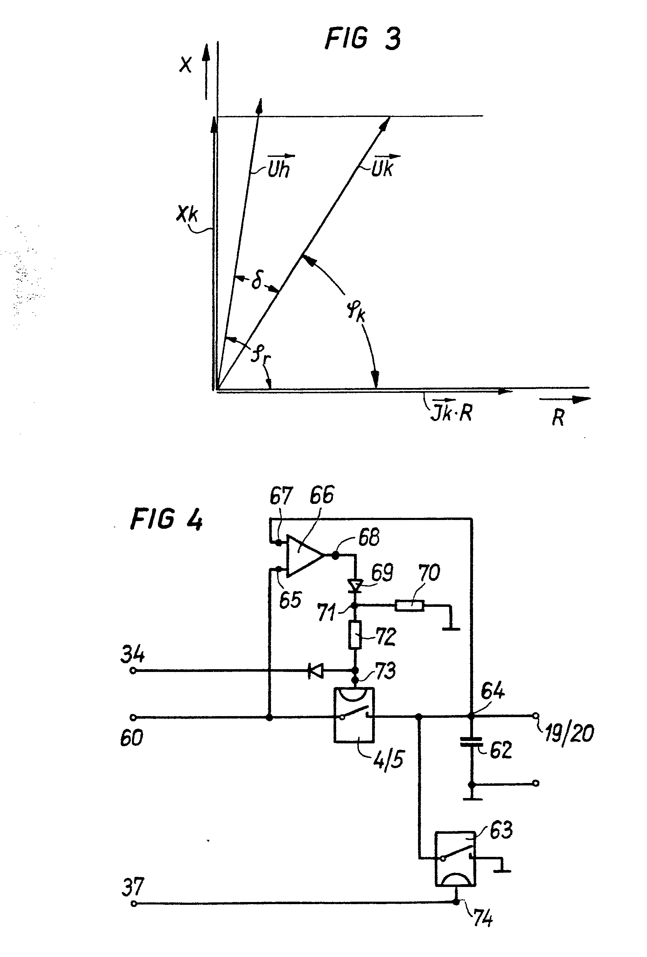

Mit dem Signal gemäss Diagramm B werden - wie bei der Erläuterung der Fig. 4 noch näher ausgeführt wird - die Kondensatoren 50 der beiden Maximalwertspeicher 46 und 47 entladen und der Zähler 45 in nicht dargestellter Weise zurückgestellt. Nach Ablauf der Zeit T1 wird am Ausgang 34 der Steuereinrichtung 33 für eine Zeit T2 ein weiteres Signal (vgl. Diagramm C der Fig. 2) erzeugt, mit dem die beiden Maximalwertspeicher 46 und 47 für die Zeit T2 zur Speicherung der Maximalwerte der Hilfsspannung $\vec{U}_h$ und der weiteren Messgrösse $\vec{U}_u$ freigegeben werden. Dies geschieht dadurch, dass von dem Signal am Ausgang 34 die Schalter 4 und 5 geschlossen werden.

Gleichzeitig mit der Speicherung der Maximalwerte der Hilfsgrösse $\vec{U}_h$ und der weiteren Messgrösse $\vec{U}_u$ werden aus diesen Messgrössen mit tels der Rechteckformer 40 und 41 entsprechende Rechteckschwingungen erzeugt und diese im Exklusiv-ODER-Glied 42 ausgewertet; am Ausgang des Exclusiv-ODER-Gliedes ergibt sich daher für die Zeit zwischen gleichartigen Nulldurchgängen der beiden Rechteckschwingungen ein Ausgangssignal. Dieses Ausgangssignal ist in der Regel kurz, weil wegen der Verwendung der Phasendreheinrichtung 2 der Phasenwinkel zwischen der Hilfsmessgrösse $\vec{U}_h$ und der weiteren Messgrösse $\vec{U}_u$ klein ist. Es ergibt sich damit spätestens nach einer Halbschwingung der Messgrössen am Ausgang des Zählers 45 bzw. am Eingang 13 des Multiplexers 14 eine Ausgangsgrösse, die vom Phasenwinkel zwischen der Hilfsmessgrösse $\vec{U}_h$

und der weiteren Messgrösse $\overrightarrow{Uu}$ bzw. der einen Messgrösse $\overrightarrow{Ui}$ und der weiteren Messgrösse $\overrightarrow{Uu}$ abhängig ist. Mit dieser Ausgangsgrösse und den während der Zeitdauer T2 gespeicherten Maximalwerten der Hilfsmessgrösse $\overrightarrow{Uh}$ und der weiteren Messgrösse $\overrightarrow{Uu}$ lässt sich dann mittels des Rechenwerkes 29 die Reaktanz und damit der Kurzschlussort bestimmen. Dies beruht auf folgendem Sachverhalt:

In Fig. 3 ist in einem R-X Diagramm der durch den Kurzschlussstrom $\overrightarrow{Jk}$ verursachte Spannungsabfall $\overrightarrow{Jk \cdot R}$ und die Kurzschlussspannung $\overrightarrow{Uk}$ eingetragen; beide Vektoren schliessen einen Phasenwinkel $\varphi_k$ ein, der den Phasenwinkel zwischen Strom und Spannung der Leitung im Kurzschlussfalle darstellt. Ausserdem ist im Vektordiagramm die Hilfsmessgrösse $\overrightarrow{Uh}$ eingetragen, die einen Phasenwinkel $\varphi_r$ mit der Abzisse bildet. Dieser Winkel entspricht etwa dem Phasenwinkel der Impedanz der Energieübertragungsleitung bei metallischem Kurzschluss. Der Phasenwinkel $\varphi_r$ wird - wie oben erwähnt - vorteilhafterweise 80° gross gewählt.

Unter Berücksichtigung der eingangs aufgeführten Gleichung (1) und unter der Annahme, dass

$$\varphi_k \leqq \varphi_r, \tag{2}$$

wobei in $\varphi_k$ eine mögliche Lichtbogenspannung berücksichtigt ist, lässt sich folgende Beziehung (3) aufstellen:

$$\varphi_k = \varphi_r - \delta, \tag{3}$$

wobei $\delta$ den Phasenwinkel zwischen $\overrightarrow{Uh}$ und $\overrightarrow{Uk}$ beschreibt.

Unter weiteren Berücksichtigungen des Umstandes, dass zur Bildung der Hilfsmessgrösse $\overrightarrow{Uh}$ eine Nachbildung $Z_Z \cdot e^{i\varphi_r}$ benützt wird, lässt sich die Hilfsmessgrösse $\overrightarrow{Uh}$ durch folgende Gleichung (4) mathematisch beschreiben:

$$\overrightarrow{Uh} = \overrightarrow{Jk} \cdot Z_N \cdot e^{i\varphi_r}. \tag{4}$$

Mit

$$|Jk \cdot R| = |Jk \cdot Z_N| \tag{5}$$

lässt sich die Gleichung (1) auch folgendermassen darstellen:

$$Xk = \frac{|\hat{U}k|}{|\hat{U}h|} \cdot [\sin(\varphi_r - \delta)] \tag{6}$$

Aus dieser Gleichung folgt mit $\varphi_r = 80°$ unter Verwendung der bekannten Additionstheoreme für Xk

$$Xk = C \cdot \frac{|\hat{U}k|}{|\hat{U}h|} \cdot (\cos\delta - K(\delta) \cdot \sin\delta) \tag{7}$$

Für kleine Winkel $\delta$, die aufgrund der Lage der Hilfsmessgrösse $\overrightarrow{Uh}$ in der Regel gegeben sind, und bei einem zugelassenen Fehler bei der Bestimmung des Kurzschlussortes von z.B. < 3%, lässt sich die Reaktanz Xk auch durch die Gleichung (8) darstellen

$$Xk = C \cdot \frac{|\hat{U}k|}{|\hat{U}h|} \cdot (1 - K(\delta) \cdot \sin\delta) \tag{8}$$

Das $\delta$ gleich dem Phasenunterschied zwischen der Hilfsmessgrösse $\overrightarrow{Uh}$ und der weiteren Messgrösse $\overrightarrow{Uu}$ und damit aufeinanderfolgender Nulldurchgänge der Rechteckschwingungen an den Ausgängen der Rechteckformer 40 und 41 und damit der Zeitdauer der Ausgangsgrösse am Exklusiv-ODER-Glied 42 ist bzw. dem Zählerstand des Zählers 45 entspricht, lässt sich aus den gespeicherten Maximalwerten der beiden Messgrössen $\overrightarrow{Uh}$ und $\overrightarrow{Uu}$ und dem Zählerstand des Zählers 45 in dem Rechenwerk 29 unter Einführung eines vorgebbaren Korrekturgliedes K ($\delta$) der Kurzschluss mit hinreichender Genauigkeit bestimmen.

Dies gilt insbesondere für die Haupteinsatzfälle der erfindungsgemässen Schaltungsanordnung zur Bestimmung des Kurzschlussortes auf Energieübertragungsleitungen mit grösseren Stationsabständen; hierbei können zwar für $\varphi_k$ auch Werte erwas über 80° auftreten, für die jedoch die Näherungsformel ebenfalls zu hinreichend genauen Ergebnissen führt. Grössere Abweichungen treten nur bei kürzeren Stationsabständen oder bei sehr grossen Erdübergangswiderständen auf.

Für diese Fälle, wo die Reaktanz bzw. der Kurzschlussort nach der Gleichung (1) genauer festgestellt werden soll, ist dem Zähler N - wie in Fig. 1 strichliert eingezeichnet - ein PROM 51 nachgeordnet, das beispielsweise so ausgebildet sein kann, wie es in dem Siemens-Datenbuch 1976/77 «Mikroprozessor-Bausteine System SAB 8080», Seite 221 ff. beschrieben ist. Mit Hilfe dieses PROMS 51 lässt sich am Eingang 13 des Multiplexers 14 eine Ausgangsgrösse erzeugen, die dem Sinus des Phasenwinkels $\varphi_k$ zwischen Kurzschlussstrom und Kurzschlussspannungen entspricht, so dass in diesem Falle von dem Rechenwerk die Reaktanz und damit auch der Kurzschlussort genauer berechenbar ist.

Jeder Maximalwertspeicher 46 bzw. 47 der Anordnung 12 zur Speicherung des Maximalwertes kann so ausgeführt sein, wie es in Fig. 4 dargestellt ist; dabei ist jedoch der Gleichrichter 48 fortgelassen und der Schalter 4 bzw. 5 nach Fig. 1 mit in die Darstellung einbezogen. Ein Kondensator 62, zu dem ein zusätzlicher Schalter 63 parallel angeordnet ist, ist mit einem Anschluss an Masse gelegt. Zwischen der Eingangsklemme 60, der die Messhilfsgrösse $\overrightarrow{Uh}$ bzw. die weitere Messgrösse $\overrightarrow{Uu}$ zugeführt ist, und dem anderen Anschlusspunkt 64 des Kondensators 62 ist der Schalter 4 bzw. 5 angeordnet. An die eine Eingangsklemme 60 ist ein Eingang 65 eines Komparators 66 angeschlossen, dessen anderer Eingang 67 mit dem anderen Anschlusspunkt 64 des Kondensators 62 verbunden ist.

An den Ausgang 68 des Komparators 66 ist ein Spannungsteiler angeschlossen, der aus der Reihenschaltung einer Diode 69 und eines Widerstandes 70 besteht. Der gemeinsame Schaltungspunkt 71 der Diode 69 und des Widerstandes 70 und damit der Abgriff des Spannungsteilers ist über einen weiteren Widerstand 72 mit einem Betätigungseingang 73 des Schalters 4 bzw. 5 verbunden.

An den Betätigungseingang 73 des Schalters 4 bzw. 5 ist der Ausgang 34 der Steuereinrichtung 33 (vgl. Fig. 1) angeschlossen. Der weitere Ausgang 37 der Steuereinrichtung 33 ist mit einem Betätigungseingang 74 des zusätzlichen Schalters 63 verbunden.

Der dargestellte Maximalwertspeicher arbeitet in folgender Weise:

Zunächst wird von der Steuereinrichtung 33 über den Ausgang 37 an den Betätigungseingang 74 des einen zusätzlichen Schalters 63 kurzzeitig ein Signal gegeben (Signal B nach Fig. 2), wodurch der Schalter 63 schliesst und damit den Kondensator 62 entlädt. Am Ausgang 34 der Steuereinrichtung 33 tritt während dieser Zeit T1 ein Signal nicht auf, so dass ungeachtet der Spannungsverhältnisse an der Eingangsklemme 60 und dem anderern Anschlusspunkt 64 des Kondensators 62 von dem Komparator 66 der Schalter 4 bzw. 5 nicht gesteuert werden kann.

Erst wenn nach Entladung des Kondensators 62 am Ausgang 34 der Steuereinrichtung 33 ein Signal (Signal C) auftritt, wird der Schalter 4 bzw. 5 vom Komparator 66 aus steuerbar. Die Steuerung des Schalters 4 bzw. 5 über den Komparator 66 erfogt in Abhängigkeit von der Spannungsdifferenz an der Eingangsklemme 60 und an dem anderen Anschlusspunkt 64 des Kondensators 62. Zunächst wird die Spannung an der Eingangsklemme 60 grösser sein als die am Anschlusspunkt 64, so dass vom Komparator 66 ein Ausgangssignal erzeugt wird und dadurch der Schalter 4 bzw. 5 betätigt wird. Der Kondensator 62 kann demzufolge aufgeladen werden. Der Ladevorgang läuft so lange, wie die Spannung am Anschlusspunkt 64 und damit am Kondensator 62 kleiner als der jeweilige Wert der zu speichernden Spannung $\overrightarrow{Uh}$ bzw. $\overrightarrow{Uu}$ an der Eingangsklemme 60 ist. Besteht zwischen der Eingangsklemme 60 und dem Anschlusspunkt 64 keine Spannungsdifferenz mehr, verschwindet das Signal am Ausgang 68 des Komparators 66, und der Schalter 4 bzw. 5 öffnet. Damit ist der Maximalwert der Spannung am Eingang 60 im Kondensator 62 gespeichert.

Der Schalter 4 bzw. 5 bleibt so lange geöffnet, wie während des Signals C am Ausgang 34 der Steuereinrichtung 33 vom Komparator 66 kein Signal an den Betätigungseingang 73 des Schalters 4 bzw. 5 gegeben wird. Tritt während des Anstehens des Signals C am Ausgang 34 der Steuereinrichtung 33 am Eingang 60 ein höherer als der bereits gespeicherte Maximalwert auf, dann wird der Schalter 4 bzw. 5 wiederum geschlossen und der Kondensator 62 bis auf diesen höheren Maximalwert aufgeladen; dieser Wert entspricht dann dem höheren Maximalwert der Spannung am Eingang 60. Am Ausgang 19 bzw. 20 der Maximalwertspeicher 46 bzw. 47 lässt sich daher eine Spannung abnehmen, die dem Maximalwert der Messgrössen $\overrightarrow{Uh}$ bzw. $\overrightarrow{Uu}$ während des Anstehens eines Signals am Ausgang 34 der Steuereinrichtug 33 entspricht.

Durch ein erneutes Signal an den Betätigungseingang 74 des zusätzlichen Schalters 63 kann der Kondensator 62 wieder entladen werden, und es kann in der oben beschriebenen Weise die Speicherung eines neuen Maximalwertes beginnen.

### Patentansprüche

1. Schaltungsanordnung zur Bestimmung der Reaktanz einer Energieübertragungsleitung im Kurzschlussfalle, der eine aus dem Kurzschlussstrom in der Energieübertragungsleitung abgeleitete Messgrösse ($\overrightarrow{Ui}$) und eine aus der Kurzschlussspannung an der Energieübertragungsleitung abgeleitete weitere Messgrösse ($\overrightarrow{Uu}$) zugeführt ist, dadurch gekennzeichnet, dass die Schaltungsanordnung eingangsseitig eine Phasendreheinrichtung (2) enthält, in der aus der einen Messgrösse ($\overrightarrow{Ui}$) eine Hilfsmessgrösse ($\overrightarrow{Uh}$) gebildet wird, die der einen Messgrösse ($\overrightarrow{Ui}$) etwa um einen der Phasendifferenz zwischen Strom und Spannung bei metallischem Kurzschluss entsprechenden Phasenwinkel voreilt, dass eine Auswerteanordnung (8) zur Bildung einer vom Phasenwinkel zwischen den beiden Messgrössen ($\overrightarrow{Ui}$, $\overrightarrow{Uu}$) abhängigen Ausgangsgrösse und über im Kurzschlussfalle betätigte Schalter (4, 5) eine Anordnung (12) zur Maximalwertspeicherung der weiteren Messgrösse ($\overrightarrow{Uu}$) und der Hilfsmessgrösse ($\overrightarrow{Uh}$) jeweils an den Ausgang des Phasendrehgliedes (2) und an die weitere Messgrösse ($\overrightarrow{Uu}$) angeschlossen sind, und dass der Ausgang (19, 20) der Anordnung (12) zur Maximalwertspeicherung und der Ausgang (13) der Auswerteanordnung (8) an eine Rechenanordnung (29) zur Ermittlung der Reaktanz angeschlossen sind.

2. Anordnung nach Anspruch 1, dadurch gekennzeichnet, dass der Rechenanordnung (29) ein Multiplexer (14) vorgeordnet ist und dass der Ausgang (19, 20) der Anordnung (12) zur Maximalwertspeicherung über eine Analog-Digital-Wandleranordnung an den Multiplexer (14) angeschlossen ist.

3. Schaltungsanordnung nach Anspruch 1 oder 2, dadurch gekennzeichnet, dass den Schaltern (4, 5) auf die Netzfrequenz abgestimmte Bandpässe (3, 6) mit gleichem elektrischem Verhalten vorgeordnet sind

4. Schaltungsanordnung nach Anspruch 1 oder 2, dadurch gekennzeichnet, dass die Auswerteanordnung (8) eingangsseitig zwei Rechteckformer (40, 41) enthält, von denen der eine (40) an seinem Ausgang eine der Hilfsmessgrösse ($\overrightarrow{Uh}$) entsprechende Rechteckschwingungen und der andere (41) eine der weiteren Messgrösse ($\overrightarrow{Uu}$) entsprechende weitere Rechteckformer (40, 41) an ein Exklusiv-ODER-Glied (42) angeschlossen sind, und dass dem Exklusiv-ODER-Glied (42) eine Umsetzeranordnung (43) nachgeordnet ist, die an ihrem Ausgang die vom Phasenwinkel zwischen den beiden Messgrössen ($\overrightarrow{Ui}$, $\overrightarrow{Uu}$) abhängige Ausgangsgrösse erzeugt.

5. Schaltungsanordnung nach Anspruch 4, dadurch gekennzeichnet, dass die Umsetzeranordnung (43) eingangsseitig einen Generator (44) enthält, der während der Zeitdauer eines Ausgangssignals des Exklusiv-ODER-Gliedes (42) an seinem Ausgang eine entsprechende Anzahl von Impulsen erzeugt, und dass dem Generator (44) ein Zähler (45) nachgeordnet ist.

6. Schaltungsanordnung nach Anspruch 5, dadurch gekennzeichnet, dass der Ausgang des Zählers (45) unmittelbar mit dem Multiplexer (14) verbunden ist.

7. Schaltungsanordnung nach Anspruch 5, dadurch gekennzeichnet, dass an den Zähler (45) ein PROM (51) angeschlossen ist, das an seinem Ausgang eine dem Sinus des Phasenwinkels ($\varphi_k$) zwischen den beiden Messgrössen ($\overrightarrow{Ui}$, $\overrightarrow{Uu}$) entsprechende Ausgangsgrösse erzeugt.

8. Schaltungsanordnung nach einem der Ansprüche 3 bis 7, dadurch gekennzeichnet, dass die Anordnung (12) zur Maximalwertspeicherung zwei Maximalwertspeicher (46, 47) enthält, von denen der eine (46) an den einen Bandpass (3) und der andere (47) an den anderen Bandpass (6) mittels der Schalter (4, 5) anschliessbar ist.

9. Schaltungsanordnung nach Anspruch 8, dadurch gekennzeichnet, dass jeder Maximalwertspeicher (46, 47) einen Kondensator (62) enthält, dem ein zusätzlicher Schalter (63) parallel geschaltet ist und der mit seinem einen Anschlusspunkt (64) über einen der Schalter (4 bzw. 5) an eine Eingangsklemme (60) angeschlossen ist, der die $\overrightarrow{}$

Hilfsmessgrösse ($\overrightarrow{Uh}$) bzw. die weitere Messgrösse ($\overrightarrow{Uu}$) zugeführt ist, und mit einem Komparator (66) versehen ist, der mit seinen Eingängen an den einen Anschlusspunkt (64) des Kondensators und an die Eingangsklemme (60) angeschlossen ist, und dass der Ausgang (68) des Komparators (66) mit dem Betätigungseingang (73) des Schalters (4 bzw. 5) verbunden ist.

10. Schaltungsanordnung nach Anspruch 9, dadurch gekennzeichnet, dass der Betätigungseingang (73) des Schalters (4 bzw. 5) über einen Widerstand (72) mit einem Abgriff (71) eines an den Ausgang (68) des Komparators (66) angeschlossenen Spannungsteilers (69, 70) verbunden ist.

11. Schaltungsanordnung nach Anspruch 10, dadurch gekennzeichnet, dass der Betätigungseingang (73) des Schalters (4 bzw. 5) über eine Diode mit einem Ausgang (34) einer Steuereinrichtung (33) verbunden ist, die an den Ausgang einer Anregeschaltung oder einer Schutzanordnung (31) angeschlossen ist, und dass an einen weiteren Ausgang (37) der Steuereinrichtung (33) der Betätigungseingang (74) des zusätzlichen Schalters (63) angeschlossen ist.

12. Schaltungsanordnung nach einem der vorangehenden Ansprüche, dadurch gekennzeichnet, dass der Eingang der Analog-Digital-Wandleranordnung (15) über einen Umschalter (16) mit dem Ausgang (19, 20) jeweils eines der beiden Maximalwertspeicher (46, 47) verbindbar ist.

**Claims**

1. A circuit arrangement for determining the reactance of an energy transmission line in the event of a short-circuit, which is supplied with a measurement value ($\overrightarrow{Ui}$) derived from the short-circuit current in the energy transmission line and a further measurement value ($\overrightarrow{Uu}$) derived from the short-circuit voltage in the energy transmission line, characterised in that at its input the circuit arrangement contains a phase rotation device (2) in which, from the first measurement value ($\overrightarrow{Ui}$) there is formed an auxiliary measurement value ($\overrightarrow{Uh}$) which leads the first measurement value ($\overrightarrow{Ui}$) approximately by a phase angle corresponding to the phase difference between current and voltage in the event of a metallic short-circuit, that there are connected to the output of the phase rotation element (2) and to the further measurement value ($\overrightarrow{Uu}$), an analysis arrangement (8) which serves to form an output value dependent upon the phase angle between the two measurement values ($\overrightarrow{Ui}$, $\overrightarrow{Uh}$) and an arrangement (12) for the maximum value storage of the further measurement value ($\overrightarrow{Uu}$) and the auxiliary measurement value ($\overrightarrow{Uh}$) via switches (4, 5) which are actuated in the event of a short-circuit, and that the output (19, 20) of the arrangement (12) for maximum value storage and the output (13) of the analysis arrangement (8) are connected to a calculating arrangement (29) which serves to determine the reactance.

2. An arrangement as claimed in Claim 1 characterised in that the calculating arrangement (29) is preceded by a multiplexer (14), and that the output (19, 20) of the arrangemend (12) for maximum value storage is connected to the multiplexer (14) via an analogue-digital converter arrangement.

3. An arrangement as claimed in Claim 1 or 2 characterised in that the switches (4, 5) are preceded by band-pass filters (3, 6) which are tuned to the mains frequency and which exhibit identical electrical characteristics.

4. An arrangement as claime in Claim 1 or 2, characterised in that at its input the analysis arrangement (8) contains two rectangular shapers (40, 41), one of which (40) produces at its output a rectangular oscillation corresponding to the auxiliary measurement value (Uh), and the other of which (41) produces a further rectangular oscillation corresponding to the further measurement value (Uu), that the outputs of the two rectangular shapers (40, 41) are connected to a EXCLUSIVE-OR gate (42), and that the EXCLUSIVE-OR gate (42) is followed by a converter arrangement (43) which at its output generates the output value dependent upon the phase angel between the two measurement values ($\overrightarrow{Ui}$, $\overrightarrow{Uu}$).

5. An arrangement as claimed in Claim 4, characterised in that at its output the converter arrangement (43) contains a generator (44) which produces a corresponding number of pulses at its output for the duration of an output signal from the EXKLUSIVE-OR gate (42), and that the generator (44) is followed by a counter (45).

6. An arrangement as claimed in Claim 5, characterised in that the output of the counter (45) is directly connected to the multiplexer (14).

7. An arrangement as claimed in Claim 5, characterised in that the counter (45) is connected to a PROM (51) which generates at its output an output value corresponding to the sine of the phase angle ($\varphi_k$) between the two measurement values ($\overrightarrow{Ui}$, $\overrightarrow{Uu}$).

8. An arrangement as claimed in one of the Claims 3 to 7, characterised in that the arrangement (12) for maximum value storage contains two maximum value stores (46, 47), on of which (46) can be connected to the first band-pass filter (3) and the other of which (47) can be connected to the other band-pass filter (6) by means of the switches (4, 5).

9. An arrangement as claimed in Claim 8, characterised in that each maximum value store (46, 47) contains a capacitor (62) connected in parallel to an additional switch (63) and connected by its first terminal point (64) via one of the switches (4 or 5) to an input terminal (60) supplied with the auxiliary measurement value ($\overrightarrow{Uh}$) and with the further measurement value ($\overrightarrow{Uu}$), and is provided with a comparator (66) connected by its inputs to the first terminal point (64) of the capacitor and to the input terminal (60), and that output (68) of the comparator (66) is connected to the actuation input (73) of the switch (4, 5).

10. An arrangement as claimed in Claim 9, characterised in that the actuation input (73) of the switch (4, 5) is connected via a resistor (72) to a tapping (71) of a voltage divider (69, 70) connected to the output (68) of the comparator (66).

11. An arrangement as claimed in Claim 10, characterised in that the actuation input (73) of the switch (4, 5) is connected via a diode to an output (34) of a control device (33) which is connected to the output of an energising circuit or a protective arrangement (31), and that a further output (37) of the control device (33) is connected to the actuation input (74) of the additional switch (63).

12. An arrangement as claimed in one of the preceding Claims, characterised in that the input of the analogue-digital converter arrangement (15) can be connected via a change-over switch (16) to the output (19, 20) of one of the two maximum value stores (46, 47).

**Revendications**

1. Circuit pour la détermination de la réactance d'une ligne de transport d'énergie en cas de court-circuit, auquel sont appliqués une grandeur mesu $\overrightarrow{}$ rée (Ui) dérivée du courant de court-circuit dans la ligne de transport d'énergie et une autre grandeur $\overrightarrow{}$ mesurée (Uu) dérivée de la tension de court-cir cuit sur la ligne de transport d'énergie, caractérisé par le fait que le circuit contient, côté entrée, un dispositif de déphasage (2) dans lequel est for- $\overrightarrow{}$ mée, à partir d'une grandeur mesurée (Ui), une $\overrightarrow{}$ grandeur mesurée auxiliaire (Uh) qui est en avance, d'un angle de déphasage qui correspond approximativement au déphasage entre le courant et la tension en cas de court-circuit métallique, par rapport à une des grandeurs mesurées $\overrightarrow{}$ (Ui), qu'un dispositif d'évaluation (8), destiné à former une grandeur de sortie qui dépend de l'angle de déphasage entre les deux grandeurs mesurées ($\overrightarrow{Ui}$, $\overrightarrow{Uu}$), et, par l'intermédiaire de com mutateurs (4, 5) actionnés en cas de court-circuit, un dispositif (12) pour la mémorisation de la va- $\overrightarrow{}$ leur maximale de l'autre grandeur mesurée (Uu) $\overrightarrow{}$ et de la grandeur mesurée auxiliaire (Uh) sont respectivement reliés à la sortie du dispositif de déphasage (2) et à l'autre grandeur mesurée (Uu⃗), et que la sortie (19, 20) du dispositif (12) pour la mémorisation de la valeur maximale et la sortie (13) du dispositif d'évaluation (8) sont reliées à un dispositif de calcul (29) pour la détermination de la réactance.

2. Agencement suivant la revendications 1, caractérisé par le fait qu'un multiplexeur (14) est monté en amont du dispositif de calcul (29), et que la sortie (19, 20) du dispositif (12) pour la mémorisation de la valeur maximale est reliée au multiplexeur (14), par l'intermédiaire d'un dispositif converisseur analogique-numérique.

3. Circuit suivant la revendication 1 ou 2, caractérisé par le fait que des filtres passe-bande (3, 6), accordés sur la fréquence du réseau er présentant le même comportement électrique, sont montés en amont des commutateurs (4, 5).

4. Circuit suivant la revendication 1 ou 2, caractérisé par le fait que le dispositif d'évaluation (8) contient, côte entrée, deux générateurs d'ondes rectangulaires (40, 41) dont un (40) délivre sur sa sortie une onde rectangulaire qui correspond à la grandeur mesuré auxiliaire (Uh⃗), et dont lautre (41) délivre une autre onde rectangulaire qui correspond à l'autre grandeur mesurée (Uu⃗), que les sorties des deux générateurs d'ondes rectangulaires (40, 41) sont reliées à un élément OU exclusif (42), et qu'en aval de l'élément OU exclusif (42) est monté un dispositif convertisseur (43) qui délivre sur sa sortie la grandeur de sortie qui dépend de l'angle de déphasage entre les deux grandeurs mesurées (Ui⃗, Uu⃗).

5. Circuit suivant la revendication 4, caractérisé par le fait que le dispositif convertisseur (43) contient, côte entrée, un générateur (44) qui délivre sur sa sortie un nombre d'impulsions correspondant pendant la durée d'un signal de sortie de l'élément OU exclusiv (42), et qu'un compteur (45) est monté en aval du générateur (44).

6. Circuit suivant la revendications 5, caractérisé par le fait que la sortie du compteur (45) est reliée directement au multiplexeur (14).

7. Circuit suivant la revendication 5, caractérisé par le fait qu'au compteur (45) est reliée une mémoire morte programmable (51) qui délivre sur sa sortie une grandeur de sortie qui correspond au sinus de l'angle de déphase ($\varphi_k$) entre les deux grandeurs mesurées (Ui⃗, Uu⃗).

8. Circuit suivant l'une des revendications 3 à 7, caractérisé par le fait que le dispositif (12) pour la mémorisation de la valeur maximale comporte deux mémoires de valeur maximale (46, 47), dont une (46) peut être raccordée à un des filtres passe-bas (3), et dont l'autre (47) peut être raccordée à l'autre filtre passe-bas (6), au moyen des commutateurs (4, 5).

9. Circuit suivant la revendication 8, caractérisé par le fait que chaque mémoire de valeur maximale (46, 47) contient un condensateur (62) en parallèle sur lequel est monté un commutateur supplémentaire (63) et dont une borne de raccordement (64) est reliée par l'intermédiaire d'un des commutateurs (4 ou 5), à une borne d'entrée (60) à laquelle est appliquée la grandeur mesurée auxiliaire (Uh⃗) ou l'autre grandeur mesurée (Uu⃗), et comporte un comparateur (66) dont les entrées sont reliées à une des bornes de raccordement (64) du condensateur et à la borne d'entrée (60), et que la sortie (68) du comparateur (66) est reliée à l'entrée d'actionnement (73) du commutateur (4 ou 5).

10. Circuit suivant la revendication 9», caractérisé par le fait que l'entrée d'actionnement (73) du commutateur (4 ou 5) est reliée, par l'intermédiaire d'une résistance (72), à une prise (71) d'un diviseur de tension (69, 70) relié à la sortie (68) du comparateur (66).

11. Circuit suivant la revendication 10, caractérisé par le fait que l'entrée d'actionnement (73) du commutateur (4 ou 5) est reliée, par l'intermédiaire d'une diode, à une sortie (34) d'un dispositif de commande (33) qui est raccordé à la sortie d'un circuit d'excitation ou à un dispositif de protection (31), et que l'entrée d'actionnement (74) du commutateur supplémentaire (63) est reliée à une autre sortie (37) du dispositif de commande (33).

12. Circuit suivant l'une des revendications précédentes, caractérisé par le fait que l'entrée du dispositif convertisseur analogique-numérique (15) peut être reliée, par l'intermédiaire d'un inverseur (16), à la sortie (19, 20) d'une des deux mémoires de valeur maximale respectives (46, 47).

## FIG 1

## FIG 2

## FIG 3

## FIG 4